# DEMANDE DE BREVET EUROPEEN

(11) **EP 1 047 132 A1**
(43) Date de publication de la demande: **25.10.2000**
(21) Numéro de dépôt: 00401086.4
(22) Date de dépôt: 19.04.2000
(51) Int. Cl.: H01L 27/06

(54) **Dispositif de circuit intégré comprenant une inductance à haut coefficient de qualité**

(30) Priorité: 20.04.1999 FR 9904986
(71) Demandeur: FRANCE TELECOM, 75015 Paris (FR)
(72) Inventeur: Merckel, Gérard, 38330 Montbonnot (FR); Pons, Michel, 38240 Meylan (FR); Senn, Patrice, 38000 Grenoble (FR); Fournier, Jean-Michel, 38240 Meylan (FR)
(74) Mandataire: Dossmann, Gérard

(57) **Abrégé**

Le circuit intégré comprend une inductance réalisée à un niveau de métallisation du circuit, une couche enterrée située dans le substrat du circuit intégré sous ladite inductance et des moyens de connexion reliant l'inductance à la couche enterrée. Les moyens de connexion sont agencés de façon à assurer un même potentiel en dynamique entre l'inductance et la couche enterrée. Cet équipotentiel est assuré par un transistor dans un montage de type suiveur réalisé dans le substrat et connecté en parallèle des capacités parasites sous l'inductance.

## Description

La présente invention concerne un dispositif de circuit intégré comprenant une inductance à haut coefficient de qualité. Le coefficient de qualité ou facteur de qualité d'une inductance, généralement nommé Q, est défini comme étant le rapport entre la partie imaginaire et la partie réelle de l'impédance de l'inductance. Ce coefficient peut être mesuré à l'aide d'un analyseur de réseau.

La réduction régulière des dimensions des dispositifs actifs tels qu'un transistor dans les circuits intégrés, en particulier sur du silicium, est nécessaire pour permettre l'augmentation de la densité d'intégration et conduit à une amélioration de leurs performances fréquentielles. Aujourd'hui, on peut intégrer des fonctions radiofréquences telles qu'un amplificateur à faible bruit (LNA, "low noise amplifier" en langue anglaise), un mélangeur, un amplificateur de puissance ou encore un oscillateur commandé par une tension (VCO, "voltage controlled oscillator" en langue anglaise) pour des fréquences supérieures à 2 GHz.

Un circuit intégré sur silicium comporte un substrat qui est du silicium intrinsèque (silicium pur) dans lequel on a introduit des impuretés tels que des atomes du groupe III dans le tableau de Mendeleïev (bore B, gallium Ga,... ), on obtient alors un silicium dopé P.

Une couche de matériau isolant, le SiO₂ par exemple, est intercalée entre le substrat et l'inductance. L'inductance est réalisée sous forme de spirale située au dernier niveau de métal qui est généralement l'aluminium.

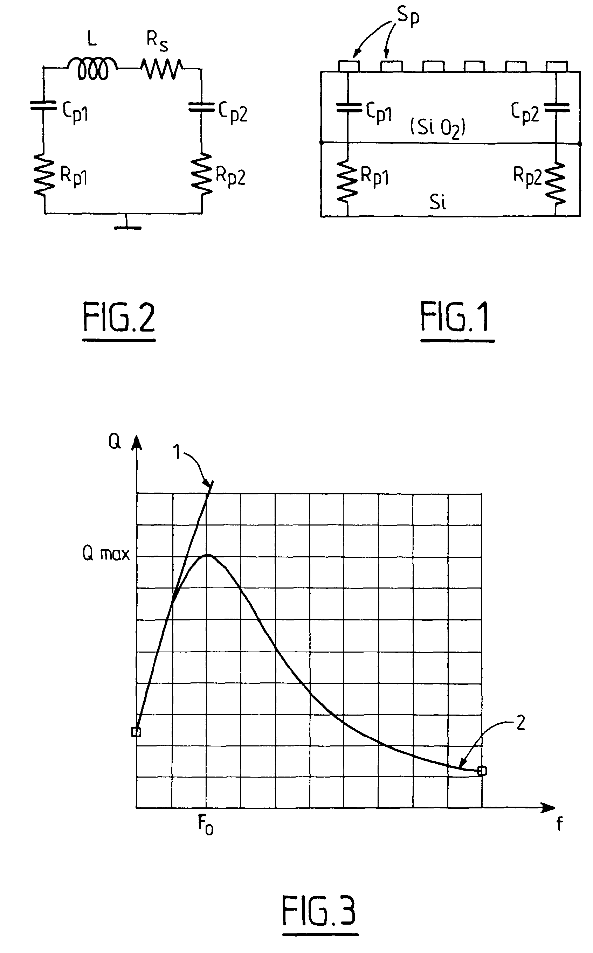

Comme on peut le voir sur la figure 1 qui est une vue en coupe de l'inductance, cette inductance est réalisée sous forme de spires Sp déposées au dessus d'une couche isolante d'oxyde de silicium SiO2 qui est elle même déposée sur un substrat en silicium Si. Pour tenir compte des effets parasites, un couplage parasite est traduit par des capacités Cp représentant la capacité de la couche isolante entre l'inductance et le substrat et des résistances de pertes Rp modélisant les pertes d'énergie dans le substrat. La figure 2 illustre une modélisation électrique de l'inductance et de ses parasites dans laquelle l'inductance est modélisée par une self-inductance pure L et une résistance série Rs, et on retrouve les capacités parasites Cp reliées aux résistances de pertes Rp.

Ainsi si on étudie l'évolution du coefficient de qualité Q en fonction de la fréquence f, on observe un comportement différent suivant le domaine de fréquence. La courbe 2 de la figure 3 représente cette évolution du coefficient de qualité Q pour une inductance réelle. A basse fréquence le facteur de qualité Q augmente avec la fréquence comme dans le cas d'une inductance idéale (Q = L2πf/Rs ) représentée par la courbe 1 sur la figure 3, puis il atteint un maximum Qmax pour une fréquence de résonance F₀. A haute fréquence ensuite Q décroît en s'éloignant de la courbe 1 représentant une inductance idéale et ce d'autant plus que les capacités parasites Cp1 et Cp2 sont importantes. Ce phénomène traduit le fait qu'à haute fréquence ces capacités Cp1 et Cp2 constituent de faibles impédances et que la dissipation d'énergie dans les résistances de pertes Rp1 et Rp2 devient importante. Les éléments parasites, que sont Cp1, Cp2, Rp1 et Rp2, limitent donc la valeur maximale Qmax du coefficient de qualité et la fréquence de résonance F₀. Au delà de F₀, l'inductance ne se comporte plus comme une véritable inductance. Il est difficile de réaliser une inductance intégrée ayant un coefficient de qualité Q élevé puisque les éléments parasites sont inhérents à sa construction. La résistance série Rs contribue également à la limitation du coefficient de qualité Q. L'ensemble résistance série et éléments parasites fait que, sur la figure 3, la courbe 2 de l'inductance réelle s'éloigne de la courbe 1 de l'inductance idéale ayant un coefficient de qualité qui augmente avec la fréquence aussi bien en basses fréquences qu'en hautes fréquences.

L'utilisation d'inductances de coefficient de qualité élevé est nécessaire dans de nombreuses situations pour permettre l'intégration de fonctions radio-fréquences (quelques GHz) avec de bonnes caractéristiques. C'est plus particulièrement le cas pour les circuits réalisant les fonctions suivantes : VCO (oscillateur commandé par une tension), PA (amplificateur de puissance), filtres, LNA (amplificateur à faible bruit).

Dans le cas des VCO la réduction du bruit de phase est fonction dans une large mesure du coefficient de qualité Q du circuit LC (composé d'inductances et de capacités) de l'oscillateur. Pour les circuits du type PA, le gain et le rendement sont largement améliorés si les éléments passifs, tels que l'inductance, présentent des pertes minimales. En outre, l'intégration de filtres passifs est facilitée par des inductances de fort coefficient de qualité.

On connaît des systèmes permettant d'augmenter le coefficient de qualité à des fréquences de plus en plus élevées en agissant sur différents paramètres :
- augmentation de l'épaisseur de la couche de métal;
- choix d'un métal moins résistif, par exemple mettre du cuivre à la place de l'aluminium;
- éloignement de la couche de métal par rapport au substrat ;
- modification locale de la résistivité du substrat en utilisant un substrat grillagé ("patterned" en langue anglaise).

Ces modifications concernent la technologie des circuits intégrés.

Dans l'état de la technique antérieure, on connaît un système d'amélioration du coefficient de qualité par élimination de la résistance de série Rs. Pour cela, on introduit un nouveau circuit actif réalisant une résistance négative en série avec la self-inductance L et la résistance série Rs. Cependant, le bon fonctionnement de ce dispositif nécessite une connaissance rigoureuse des valeurs des composants, notamment une valeur absolue de la résistance négative ne dépassant pas la valeur de la résistance série Rs au risque d'engendrer un phénomène d'oscillation. Ce système ne permet pas d'éliminer de façon suffisante les éléments parasites limitant la valeur du coefficient de qualité Q et la fréquence de résonance F₀.

L'invention vise à apporter une solution à ce problème en diminuant l'influence des capacités parasites et des résistances de pertes vis-à-vis de l'inductance.

L'invention a pour objet d'améliorer le coefficient de qualité Q.

L'invention propose un circuit intégré comprenant une inductance réalisée à un niveau de métallisation du circuit et une couche enterrée située dans le substrat du circuit intégré sous ladite inductance.

Selon une caractéristique générale de l'invention, le circuit intégré comporte des moyens de connexion reliant l'inductance à la couche enterrée et agencés de façon à assurer un même potentiel en dynamique entre l'inductance et la couche enterrée. Le signal à la sortie de l'inductance est reproduit à l'identique, même phase et même amplitude, au niveau de la couche enterrée. Les bornes des capacités parasites, plus particulièrement de la capacité parasite Cp2, sont ainsi au même potentiel en dynamique, ce qui permet de rendre la capacité Cp2 invisible par le circuit. Les effets néfastes de celle-ci n'affectent donc plus l'inductance. On peut ainsi augmenter la fréquence de fonctionnement de l'inductance intégrée.

De préférence, les moyens de connexion comportent un transistor dans un montage de type suiveur réalisé dans le substrat. Avantageusement, ce transistor dans un montage de type suiveur est un transistor bipolaire polarisé en émetteur suiveur. La caractéristique "suiveur" permet de "recopier" le signal présent sur une borne de l'inductance au niveau de la couche enterrée. En outre, les résistances de pertes Rp sont ainsi alimentées non plus par l'inductance, mais par un courant venant du transistor. Pour éviter un surplus de coût d'intégration et de consommation d'énergie dû au composant actif qu'est le transistor, on utilise avantageusement un transistor déjà implanté dans le circuit intégré tel qu'un transistor utilisé comme tampon ("buffer" en langue anglaise) dans un circuit amplificateur à faible bruit (LNA) par exemple.

Selon une variante de l'invention, le transistor dans un montage de type suiveur peut être un transistor MOS (Métal Oxyde Semiconducteur). Ce transistor MOS peut être associé ou non à un transistor bipolaire dans un montage de type suiveur.

Selon une autre variante avantageuse de l'invention, les moyens de connexion comprennent, entre le transistor et la couche enterrée, une résistance de valeur suffisamment faible pour assurer sensiblement un même potentiel entre l'inductance et la couche enterrée. Cette résistance de faible valeur permet d'éviter d'éventuels problèmes d'oscillation pouvant subvenir lorsque la résistance série Rs est très faible de l'ordre de 1,5 Ohms ou inférieure à cette valeur. La résistance de faible valeur que l'on ajoute a une valeur de l'ordre de 5 Ohms. Cette valeur est faible par rapport à la valeur des résistances de pertes Rp qui est de plusieurs centaines d'Ohms tels que 250 Ohms par exemple. Cette différence de grandeur garantit que le transistor est toujours considéré comme un générateur de tension imposant un potentiel à la couche enterrée sensiblement identique au potentiel de l'inductance du fait qu'on dispose entre la couche enterrée et l'émetteur du transistor, une résistance de faible valeur par rapport à la résistance de charge que sont les résistances de pertes. Ainsi cette résistance ajoutée évite d'éventuelles oscillations et en raison de sa faible valeur conserve l'inductance et la couche enterrée équipotentielles.

Selon un mode de mise en oeuvre de l'invention, le circuit intégré fonctionnant à une fréquence de travail donnée, la fréquence de transition du transistor est avantageusement supérieure à la fréquence de travail. Ainsi les caractéristiques du transistor ne sont pas dégradées, en particulier son gain de transconductance, pour une fréquence de travail donnée.

Par ailleurs, la couche enterrée est préférentiellement une couche de type grillagée ("patterned"). Elle peut être également non grillagée ou encore faite d'un matériau métallique. Dans tous les cas, cette structure minimise le couplage de l'inductance avec le substrat.

Selon l'invention, on polarise le transistor de telle façon que le courant le traversant est capable de charger des capacités parasites apparaissant entre la couche enterrée et le substrat du circuit intégré. Le courant de polarisation du transistor est ainsi fixé de façon à obtenir un compromis entre un comportement en fréquence optimal du transistor et une consommation raisonnable.

L'invention propose donc un procédé pour améliorer le coefficient de qualité d'une inductance dans un circuit intégré. D'une façon générale on relie ladite inductance à une couche enterrée dans le substrat du circuit intégré de façon à rendre l'inductance et la couche enterrée équipotentielles en dynamique.

On peut connecter un transistor dans un montage de type suiveur entre l'inductance et la couche enterrée pour maintenir un même potentiel entre l'inductance et la couche enterrée.

On peut relier le transistor et la couche enterrée à l'aide d'une résistance.

Avantageusement, on polarise le transistor de telle façon que le courant le traversant est capable de charger des capacités parasites apparaissant entre la couche enterrée et le substrat du circuit intégré.

Il est décrit ci-après, à titre d'exemple nullement limitatif et en référence aux dessins annexés, un dispositif selon l'invention.
- La figure 4 est un schéma électrique de l'inductance et du transistor suiveur.
- La figure 5 illustre l'évolution du coefficient de qualité en fonction de la fréquence de transition : la courbe 3 selon l'invention et la courbe 4 selon l'état de la technique.
- La figure 6 illustre l'évolution de la fréquence de transition en fonction du courant de polarisation de collecteur pour trois types de transistors.
- La figure 7 est une vue en coupe simplifiée de l'inductance et du transistor suiveur avec une modélisation simplifiée de l'inductance.
- La figure 8 est un schéma électrique simplifié d'un amplificateur connecté à un mélangeur.

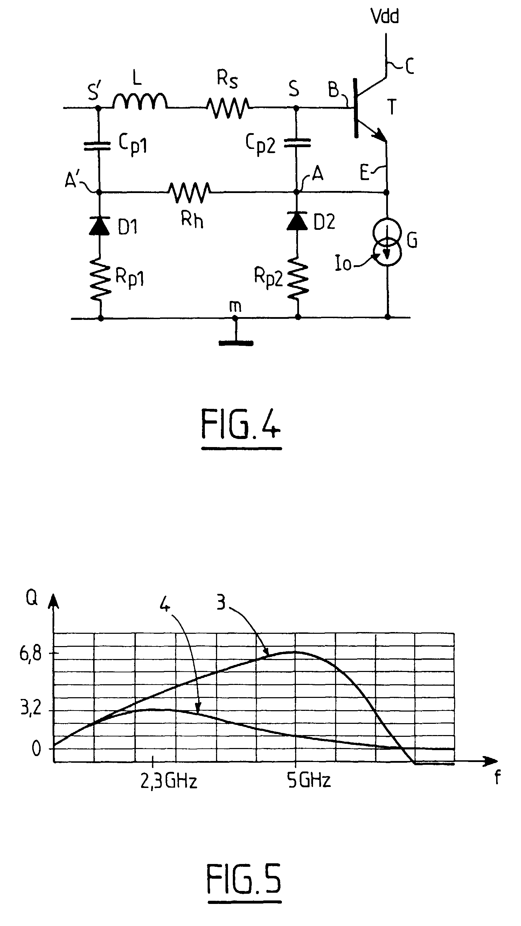

La figure 4 illustre un modèle de l'inductance du même type que celui de la figure 3 avec la self-inductance pure L de 5 nH connecté en série avec la résistance série Rs de 16 Ω, les deux extrémités de cet ensemble sont un point S' du côté de la self-inductance L et un point S du côté de la résistance série Rs. Les deux capacités parasites Cp1 et Cp2 de 0,13 pF sont respectivement connectées par une extrémité aux points S' et S. Une résistance Rh est disposée entre les deux extrémités libres des capacités Cp1 et Cp2, c'est-à-dire les points A' et A. La résistance Rh d'environ 50 Ω représente la couche enterrée. Entre le point A' et un point m représentant la masse, on a une diode D1 dont la cathode est du côté du point A' et la résistance de pertes Rp1 de 410 Ω. Entre le point A et le point m, on a une diode D2 dont la cathode est du côté du point A et la résistance de pertes Rp2 de 250 Ω. Les diodes D1 et D2 étant toujours polarisées en inverse, elles peuvent être considérées comme deux capacités Cd1 et Cd2. Le point S représente la sortie de l'inductance, la résistance série Rs modélisant la résistance de l'inductance.

On connecte un transistor bipolaire T de type npn de telle façon que sa base se trouve reliée au point S et son émetteur se trouve relié au point A en parallèle de la capacité Cp2. Le transistor T est polarisé en émetteur suiveur à l'aide d'un courant de polarisation I₀ et d'un circuit de polarisation non représenté. Le courant de polarisation I₀ est produit par un générateur de courant G connecté entre l'émetteur du transistor situé au point A et le point m. La tension alternative base-émetteur du transistor T est maintenue nulle en dynamique sur une grande gamme de fréquences, ce qui permet d'annuler l'effet de couplage dû à Cp2 avec le substrat. L'influence de Cp1 est également atténué mais avec une efficacité moindre.

En radio-fréquence, à l'aide de ce transistor dans un montage de type suiveur, les bornes de la capacité Cp2 sont sensiblement au même potentiel et celle-ci n'est donc plus vue par le circuit. L'énergie dissipée par les résistances de pertes Rp1 et Rp2 est maintenant fournie non plus par l'inductance mais par le transistor T. Une fraction du courant d'émetteur est en effet injectée dans les résistances Rp1 et Rp2 via les capacités de diode Cd1 et Cd2. Ainsi l'inductance n'est plus amortie par les résistances Rp1 et Rp2 par rapport au cas sans transistor de type suiveur dans lequel les résistances Rp1 et Rp2 étaient directement alimentées par l'inductance à travers les capacités parasites Cp1 et Cp2.

L'inductance voit sur la base du transistor une impédance élevée, cela équivaut à réduire fortement les capacités Cp1 et Cp2.

On augmente ainsi le facteur de qualité Q et la fréquence F₀ pour laquelle la surtension est maximale, soit Q égal Qmax.

Cette réduction apparente de Cp1 et Cp2 rend également possible l'augmentation de la surface de l'inductance avec comme conséquence la diminution de Rs et par conséquent dans ce cas également une amélioration du facteur de qualité.

Les capacités Cd1 et Cd2, qui sont de l'ordre de quelques picofarads, doivent pouvoir être chargées par le transistor T. Le transistor T possède donc une transconductance élevée de façon à pouvoir fournir un courant suffisamment élevé.

Une inductance selon l'invention possède un coefficient de qualité qui varie suivant un coefficient de qualité idéal (voir figure 3) tant que la fréquence de travail reste dans une plage pour laquelle le transistor fonctionne correctement, c'est-à-dire une fréquence pour laquelle le gain en courant du transistor est bien supérieur à un, par exemple supérieur à dix. Cette fréquence de transition du transistor doit donc être suffisamment élevée pour ne pas limiter le coefficient de qualité. Par ailleurs, le gain en courant du transistor suiveur doit être très supérieur à l'unité pour que le transistor suiveur fonctionne dans de bonnes conditions.

Sur la figure 5, on voit deux courbes du coefficient de qualité Q en fonction de la fréquence de travail (fréquence de fonctionnement du circuit). La courbe 3 concerne une inductance intégrée selon l'invention. La courbe 4 concerne une inductance intégrée selon l'état de la technique, c'est-à-dire sans transistor dans un montage de type suiveur. Le paramètre Q sur la courbe 3 croît avec la fréquence en basses fréquences jusqu'à une valeur maximum de 6,8 pour une fréquence de 5 GHz, puis décroît avec la fréquence en hautes fréquences sous l'effet de la limitation de la fréquence de transition du transistor dans un montage de type suiveur. Alors que dans le cas d'une inductance sans le transistor suiveur, la courbe 4 du coefficient de qualité croît avec la fréquence en basses fréquences jusqu'à une valeur maximum de 3,2 pour une fréquence de 2,3 GHz, des valeurs bien inférieures à celles de la courbe 3, puis décroît avec la fréquence en hautes fréquences sous l'effet des éléments parasites tels que les capacités Cp1, Cp2 et les résistances Rp1, Rp2. La cause du fléchissement de la courbe n'est pas la même entre les courbes 3 et 4. La présence du transistor dans un montage de type suiveur a donc bien pour effet d'augmenter le coefficient de qualité Q ainsi que la fréquence pour laquelle celui-ci est maximum. On observe ici un accroissement d'un facteur supérieur à 2.

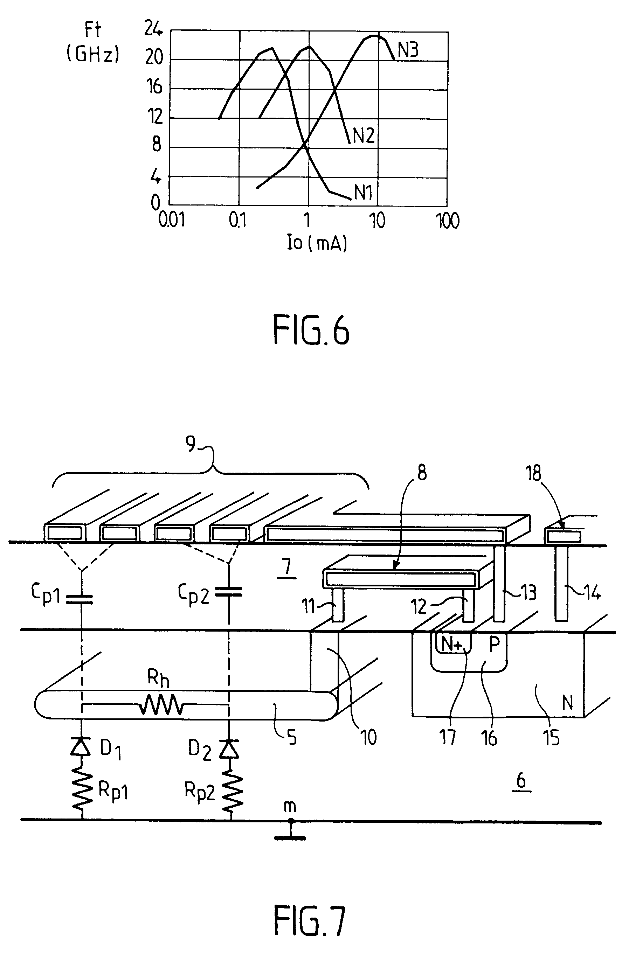

La figure 6 montre l'évolution de la fréquence de transition Ft en fonction du courant de polarisation I₀ pour trois types de transistors de surfaces d'émetteurs différentes et une tension d'alimentation de 1,5 volts. La courbe N1 correspond à un transistor T_{N1} de surface d'émetteur égale à S_{N1}. La courbe N2 correspond à un transistor T_{N2} de surface d'émetteur égale à S_{N2}. La courbe N3 correspond à un transistor T_{N3} de surface d'émetteur égale à S_{N3}. Ces surfaces sont telles que S_{N1}<S_{N2}<S_{N3}. Les transistors T_{N1} et T_{N2} sont optimisés pour leur fréquence de transition par un courant de polarisation inférieur au milli-ampère du fait de leur surface inférieure à celle du transistor T_{N3} qui lui est optimisé pour un courant I₀ de 8 mA. Ces transistors ont une fréquence de transition maximale comprise entre 20 GHz et 24 GHz. Le transistor T_{N2} donne le meilleur résultat dans la mesure où il permet d'obtenir la plus faible tension aux bornes de la capacité parasite Cp2 (0,8 fois celle obtenue avec le transistor T_{N2}) et le facteur de qualité le plus élevé (6,8 au lieu de 4,4 obtenu avec T_{N2}). Il possède les caractéristiques suivantes: (bibliothèque BiCMOS5 : N4E1) surface d'émetteur A = 0.35*4.55 µm²; I = 1 mA; Ft = 22 GHz.

Le schéma électrique de la figure 4 est illustré sous forme technologique sur la figure 7. On distingue sur la figure 7 un substrat 6 sur lequel est déposé une couche 7 d'isolant SiO2. Un point m représente la surface inférieure du substrat 6. Ce substrat 6 est composé de silicium dopé P et comporte à l'intérieur une couche enterrée 5 dopée N+ et caractérisée par une résistance Rh. La jonction entre la couche enterrée 5 et le substrat 6 est modélisée par la diode D1, connectée par sa cathode à une extrémité de la résistance Rh, ladite diode D1 étant en série avec la résistance Rp1 reliée d'un autre côté au point m. Cette jonction entre la couche enterrée 5 et le substrat 6 est également modélisée par la diode D2, connectée par sa cathode à l'autre extrémité de la résistance Rh, ladite diode D2 étant en série avec la résistance Rp2 reliée d'un autre côté au point m. Une portion 10 de silicium dopé N+ située dans le substrat est connectée à la couche enterrée 5 et à la couche isolante 7.

Dans le substrat, à côté de la couche enterrée, on implante un transistor T bipolaire de façon classique. Pour cela, on crée d'abord une portion 15 de silicium dopé N dans le substrat 6 avec une surface de la portion 15 en contact avec la couche isolante 7. Un contact 14 en aluminium situé dans la couche isolante 7 est connecté à cette portion 15. Une portion 16 de silicium dopé P est ensuite créee dans la portion 15 avec une surface de la portion 16 en contact avec la couche isolante 7. Un contact 13 en aluminium situé dans la couche isolante 7 est connecté à cette portion 16. Puis une portion 17 de silicium dopé N+ est créee dans la portion 16 avec une surface de la portion 17 en contact avec la couche isolante 7. Un contact 12 en aluminium situé dans la couche isolante 7 est connecté à cette portion 17. Le transistor T est formé par 15, 16 et 17. Par la suite, on désignera par l'émetteur le contact 12, par la base le contact 13 13 et par le collecteur le contact 14. L'émetteur 12 est relié à une extrémité d'une portion métallique 8 située dans la couche isolante 7. Un contact métallique 11 relie la portion métallique 8 et la portion 10 de silicium dopé N+. La couche enterrée 5 et l'émetteur 12 sont donc reliés par les éléments 10, 11 et 8.

La couche isolante 7 s'étend au dessus de la couche enterrée 5 et du transistor T. Le collecteur 14 est connecté à une couche métallique 18, par laquelle le transistor est alimenté en tension, au dessus de la couche isolante 7.

On dépose une spirale métallique 9 au dessus et en contact de la couche isolante 7. Cette couche métallique 9 s'étend au dessus de la couche enterrée 5 et d'une partie du transistor T, en particulier les portions 16 et 17. La couche métallique 9 forme l'inductance et elle est reliée à la base 13 du transistor T. La couche isolante 7 est modélisée par deux capacités parasites Cp1 et Cp2 reliées d'un côté à l'inductance 9 et de l'autre côté chacune à une extrémité de la résistance Rh.

La couche enterrée 5 est faiblement résistive (Rh) de façon à présenter une surface équipotentielle. Cette couche enterrée 5 est implantée "découpée" ou "grillagée". La couche enterrée peut ne pas être "découpée" ou "grillagée" mais continue et/ou faite d'un matériau métallique. Dans tous les cas elle est réalisée de manière à minimiser le couplage avec le substrat et par conséquent les pertes électromagnétiques

Par ailleurs, dans différentes variétés de circuits pour applications radio-fréquences, une couche enterrée N+ est déjà prévue et le type de transistor suiveur est déjà implanté et utilisé comme tampon. Dans ce cas il suffit de réaliser la connexion d'émetteur avec la couche enterrée N+, ce qui nécessite principalement une modification du masque servant à la réalisation du niveau de métal 8 référencé sur la figure 7.

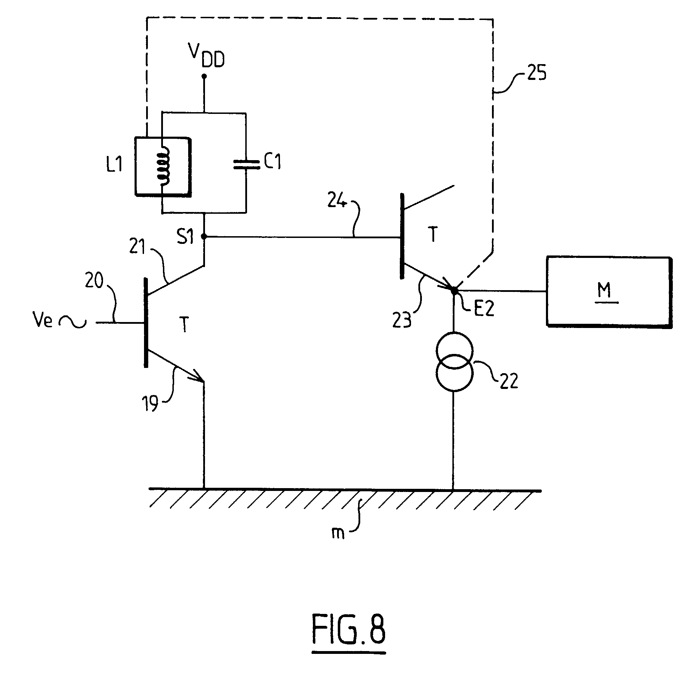

Un tel circuit est par exemple un amplificateur LNA (amplificateur à faible bruit) tel que représenté sur la figure 8. Cet amplificateur est constitué d'un transistor T1 pour lequel l'émetteur 19 est relié à la masse et la base 20 accepte un signal d'entrée Ve. Le collecteur 21 de ce transistor T1 est connecté à une extrémité S1 d'un circuit bouchon composé d'une inductance intégrée L1 en parallèle avec une capacité intégrée C1 (non parasite). L'autre extrémité du circuit bouchon est relié à une tension d'alimentation Vdd. Un signal de sortie VS1 est mesuré au point S1. Ce circuit permet d'avoir un facteur d'amplification (VS1/Ve) très élevé autour d'une fréquence de résonance F1 donnée dépendant du coefficient de qualité de l'inductance L1. Pour fonctionner à des fréquences supérieures à F1, on peut améliorer le coefficient de qualité selon l'invention en agissant sur l'inductance L1.

Cependant, ce genre de circuit est généralement suivi d'un autre circuit tel qu'un circuit mélangeur M. Ce mélangeur nécessite pour son fonctionnement d'être précédé par un circuit d'impédance de sortie faible. A cet effet, on intercale entre l'amplificateur LNA (constitué par T1, L1 et C1) et le mélangeur M un transistor bipolaire T2 polarisé en émetteur suiveur à l'aide d'un générateur de courant 22 connecté à l'émetteur 23 du transistor T2. La base 24 du transistor T2 est reliée à la sortie de l'amplificateur LNA au point S1. Le mélangeur M est connecté au transistor T2 par l'émetteur 23. Ainsi le signal VS1 est reproduit en E2 car T2 est un transistor suiveur, et le mélangeur voit à son entrée une impédance faible qui est l'impédance de sortie du transistor bipolaire T2.

Alors, pour augmenter le coefficient de qualité, donc augmenter la fréquence de fonctionnement de l'amplificateur LNA, on utilise le transistor T2 qui est dans un montage de type suiveur. On réalise une connexion 25 entre l'émetteur 23 et une couche enterrée (non représentée) sous l'inductance intégrée L1. L'amélioration du coefficient de qualité n'a que pour coût la réalisation de la connexion 25.

L'introduction d'un transistor dans un montage de type suiveur dans le circuit électrique d'une inductance intégrée et le fait de connecter l'émetteur de cet élément actif a une couche enterrée située dans le substrat sous l'inductance pour mettre celles-ci au même potentiel en dynamique, permettent de minimiser l'influence des éléments parasites en améliorant ainsi le facteur de qualité. On peut ainsi augmenter l'épaisseur de la couche métallique réalisant l'inductance intégrée de façon à diminuer les résistances séries et améliorer encore de ce fait le coefficient de qualité. En outre, la consommation d'énergie supplémentaire due à cet élément actif (le transistor) est avantageusement maîtrisée.

## Revendications

1. Circuit intégré, comprenant une inductance réalisée à un niveau de métallisation du circuit et une couche enterrée située dans le substrat du circuit intégré sous ladite inductance, caractérisé par le fait que le circuit intégré comporte des moyens de connexion reliant l'inductance à la couche enterrée et agencés de façon à assurer un même potentiel en dynamique entre l'inductance et la couche enterrée.

2. Circuit intégré selon la revendication 1, caractérisé par le fait que les moyens de connexion comportent un transistor dans un montage de type suiveur réalisé dans le substrat.

3. Circuit intégré selon la revendication 2, caractérisé par le fait que le transistor dans un montage de type suiveur est un transistor bipolaire polarisé en émetteur suiveur.

4. Circuit intégré selon la revendication 2, caractérisé par le fait que le transistor dans un montage de type suiveur est un transistor MOS (Métal Oxyde Semiconducteur).

5. Circuit intégré selon la revendication 2, caractérisé par le fait que les moyens de connexion comprennent, entre le transistor et la couche enterrée, une résistance de valeur suffisamment faible pour assurer sensiblement un même potentiel entre l'inductance et la couche enterrée.

6. Circuit intégré selon l'une quelconque des revendications 2 à 5, apte à fonctionner à une fréquence de travail, caractérisé par le fait que la fréquence de transition du transistor est largement supérieure à la fréquence de travail.

7. Circuit intégré selon l'une quelconque des revendications précédentes, caractérisé par le fait que la couche enterrée est une couche de type "grillagée".

8. Procédé pour améliorer le coefficient de qualité d'une inductance dans un circuit intégré, caractérisé par le fait qu'on relie ladite inductance à une couche enterrée dans le substrat du circuit intégré de façon à rendre l'inductance et la couche enterrée équipotentielles en dynamique.

9. Procédé selon la revendication 8, caractérisé par le fait qu'on connecte un transistor dans un montage de type suiveur entre l'inductance et la couche enterrée pour maintenir un même potentiel en dynamique entre l'inductance et la couche enterrée.

10. Procédé selon la revendication 9, caractérisé par le fait qu'on relie le transistor et la couche enterrée à l'aide d'une résistance de faible valeur.

11. Procédé selon la revendication 9, caractérisé par le fait qu'on polarise le transistor de telle façon que le courant le traversant est capable de charger des capacités parasites apparaissant entre la couche enterrée et le substrat du circuit intégré.
